Europäisches Patentamt

European Patent Office

Office européen des brevets

(19)

(11) Numéro de publication : **0 660 105 A1**

(12)

# DEMANDE DE BREVET EUROPEEN

(21) Numéro de dépôt : **94402856.2**

(51) Int. Cl.[6] : **G01N 17/00**

(22) Date de dépôt : **12.12.94**

(30) Priorité : **20.12.93 FR 9315304**

(43) Date de publication de la demande :
**28.06.95 Bulletin 95/26**

(84) Etats contractants désignés :
**DE GB**

(71) Demandeur : **FRANCE TELECOM**
**Etablissement autonome de droit public,**
**6, Place d'Alleray**
**F-75015 Paris (FR)**

(72) Inventeur : **Blanc, Hervé Joseph**
**Foyer du Pellet,**
**19 Rue de Kerwenet**
**F-22560 Trebeurden (FR)**
Inventeur : **Glasser, Jean**
**12 Rue de l'Ile Grande**
**F-22560 Trebeurden (FR)**

(74) Mandataire : **Cabinet Martinet & Lapoux**
**BP 405**
**F-78055 Saint Quentin en Yvelines Cédex (FR)**

(54) **Procédé et système de détermination de la fonction caractéristique bidimensionelle d'une cellule photosensible.**

(57) Un faisceau lumineux produit par une lampe (10) est projeté à travers une mire (MIRE) sur l'une de cellules photosensibles ($CP_{1,1}$ - $CP_{N,P}$) d'un analyseur d'image (13). La mire (MIRE) est sous la forme d'une lame transparente dont une portion de face supportant un matériau opaque est limitée par des chants de la lame et un angle droit. Par déplacement pas à pas de la mire suivant deux directions dans le plan de mire sont obtenues des amplitudes de signal électrique ($R_{xi,yj}$) produits par la cellule photosensible à caractériser. Par lissage et dérivée partielle bidimensionnelle des amplitudes de signal électrique, sous la forme d'une matrice bidimensionnelle, est obtenue la fonction caractéristique bidimensionnelle de la cellule. L'invention sert à déterminer la résolution spatiale d'un analyseur.

FIG.5

EP 0 660 105 A1

La présente invention a trait au domaine de l'imagerie électronique. Plus particulièrement, la présente invention vise à fournir des procédé et système pour déterminer la fonction caractéristique d'un capteur élémentaire appartenant ou bien à un analyseur d'image à cellules photosensibles discrètes ou bien à un système de prise d'image incluant un tel analyseur. L'analyseur d'image est par exemple une barette d'analyse dans un télécopieur, ou un composant matriciel d'analyse dans une caméra vidéo. Le système de prise d'image est la caméra vidéo elle-même.

L'obtention de la fonction caractéristique d'une unique cellule photosensible de l'analyseur permet la caractérisation de l'analyseur pris dans son ensemble. La connaissance d'une telle fonction caractéristique peut donc être utilisée, à titre d'exemple, pour le calcul de la résolution spatiale de l'analyseur ou à des fins d'optimisation des éléments optiques dans une caméra.

Un tel analyseur peut être linéaire sous la forme d'une barette de M cellules photosensibles en ligne, ou peut être matriciel sous la forme d'une matrice de (N x P) cellules photosensibles disposées en N lignes et P colonnes. Par exemple, chaque cellule photosensible est une photodiode ou une cellule MOS et transforme une énergie lumineuse incidente en une charge électrique dans une région semiconductrice dans la cellule. Chaque cellule photosensible est en outre associée à un moyen de lecture de charge électrique qui transforme sous forme de signal électrique, à des instants d'échantillonnage périodiques, une charge emmagasinée dans la cellule et qui est dépendante d'un éclairement lumineux reçu par la cellule.

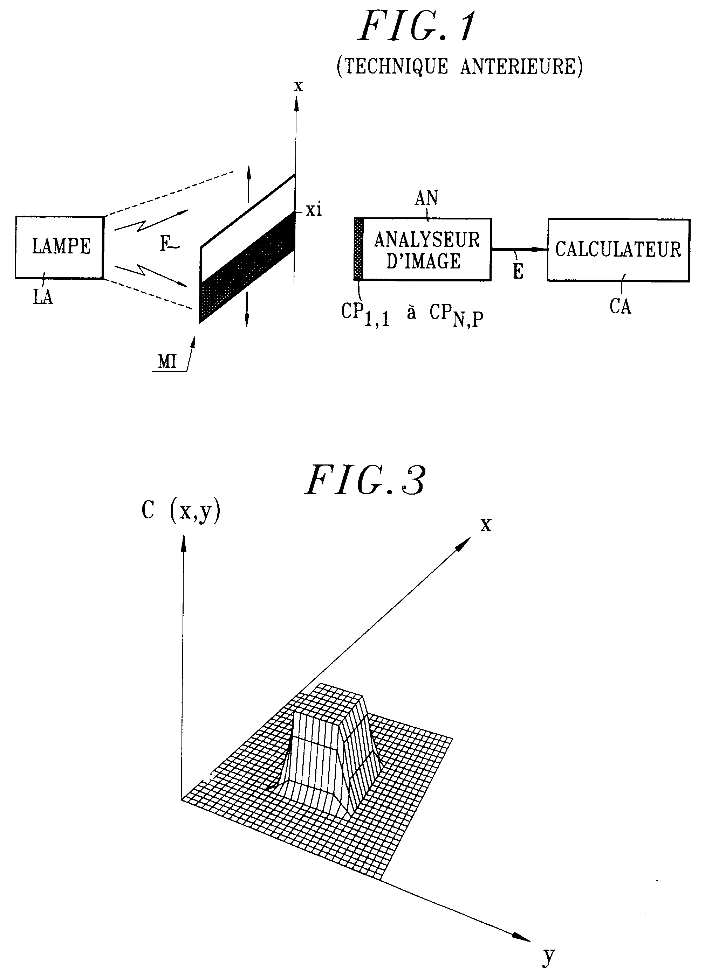

Selon la technique antérieure, la fonction caractéristique d'une cellule photosensible d'un analyseur d'image est déterminée selon un procédé dit du "bord de couteau", tel que rappelé dans l'article produit par l'un J. GLASSER des inventeurs de la présente demande, intitulé "An accurate method for measuring the spatial resolution of integrated image sensors", et paru dans PROCEEDINGS OF SPIE, vol. 1027, pages 40-47, 19-21 septembre 1988. Un système pour la mise en oeuvre de ce procédé connu est montré à la figure 1. Le système comprend une lampe LA, une mire MI, un analyseur d'image AN et un calculateur CA disposés successivement selon cet ordre. La mire MI est placée entre la lampe LA et l'analyseur AN et est par exemple sous la forme d'une lame de verre, typiquement carrée ou rectangulaire. Une moitié de l'une des faces de la lame est rendue opaque grâce à un dépôt de matière, telle qu'aluminium, illustré en zone ombrée dans la figure 1. La mire MI présente ainsi deux bandes contiguës et respectivement opaque et transparente. La mire MI est disposée perpendiculairement à l'axe d'un faisceau lumineux F produit par la lampe LA et parallèlement au plan des cellules photosensibles de l'analyseur AN.

Chacune des NxP cellules photosensibles de l'analyseur présente une surface sensible plane associée à un pixel et possédant une largeur donnée 1 et une hauteur donnée h. Par projection du faisceau lumineux F suivant une direction perpendiculaire au plan de la mire sur les cellules $CP_{1,1}$ à $CP_{N,P}$ à travers la mire MI, P cellules $CP_{n,1}$ à $CP_{n,P}$ d'une nième ligne de cellules de l'analyseur matriciel AN coïncidant avec une ligne de séparation des bandes opaque et transparente de la mire reçoivent une distribution d'éclairement lumineux $I_M(x,y)$ définie par :

$$\left\{ \begin{array}{l} I_M(x,y) = "1" \; pour \;\; xi \leq x < +\infty \\ I_M(x,y) = "0" \; pour \; -\infty < x < xi \; , \end{array} \right. \tag{1}$$

où xi dénote la hauteur de la ligne de séparation séparant des bandes opaque et transparente de la mire MI suivant un axe vertical x porté par un chant de la mire .

Ainsi chacune $CP_{n,p}$ des cellules $CP_{n,1}$ à $CP_{n,P}$ de la ligne de séparation reçoit un éclairement lumineux maximal "1" sur une première portion supérieure de sa surface sensible, et un éclairement lumineux nul "0" sur une seconde portion inférieure complémentaire à la première portion. Une intensité de signal électrique E produit par la cellule $CP_{n,p}$, lorsque la ligne de séparation des deux bandes de la mire est localisée à la hauteur xi, est notée E(xi).

Le procédé associé à un tel système est mis en oeuvre de la manière suivante. Pour plusieurs localisations à des hauteurs x1 à xl de la ligne de séparation des deux bandes de la mire MI sont déduites respectivement des intensités E(x1) à E(xl) du signal E. Les hauteurs extrêmes x1 et xl de la ligne de séparation sont telles que la cellule $CP_{n,p}$ reçoit respectivement un éclairement lumineux maximal "1" et un éclairement nul "0" sur toute sa surface sensible.

Le calculateur CA calcule à partir des l intensités du signal électrique E(x1) à E(xl), (l - 1) pentes différentielles respectivement égales à :

[ [E(x2) - E(x1)]/(x2 - x1)],
[ [E(x3) - E(x2)]/(x3 - x2)],

... , et

2

[ [E(xI) - E(x(I - 1))]/(xI - x(I - 1))],

avec (x2 - x1) = (x3 - x2) = ..... = (xI - x(I-1)) définissant le pas de déplacement de la ligne de séparation des deux bandes de la mire MI.

Puis le calculateur CA obtient une fonction continue $\frac{dE(x)}{dx}$ de x par lissage de la fonction discrète de x prenant des valeurs de pente différentielle supposées ici égales à [E(xi) - E(x(i-1))] / (xi- x(i-1), avec $1<i\leqq I$. Cette fonction continue possède la propriété démontrée ci-après.

La fonction E(xi) peut s'écrire

$$E(xi) \ = \ \int_x \int_y C(x) . I_M(x,y) . dx . dy \qquad (2)$$

où C(x) désigne la fonction caractéristique monodimensionnelle de la cellule photosensible CP$_{n,p}$ considérée, avec C($\infty$)=0 , et I$_M$(x,y) est telle que définie dans les relations (1).

La fonction E(xi) s'écrit alors :

$$E(xi) \ = \ \int_{-\infty}^{+\infty} dy \int_{xi}^{+\infty} C(x,y) . dx$$

soit:

$$\frac{\partial E(xi)}{\partial xi} \ = \ \int_{-\infty}^{+\infty} dy \int_{xi}^{+\infty} \frac{\partial}{\partial xi} C(x,y) . dx \qquad (3)$$

Il en résulte que :

$$\frac{\partial E(xi)}{\partial xi} \ = \ \int_{-\infty}^{+\infty} C(xi, y) . dy$$

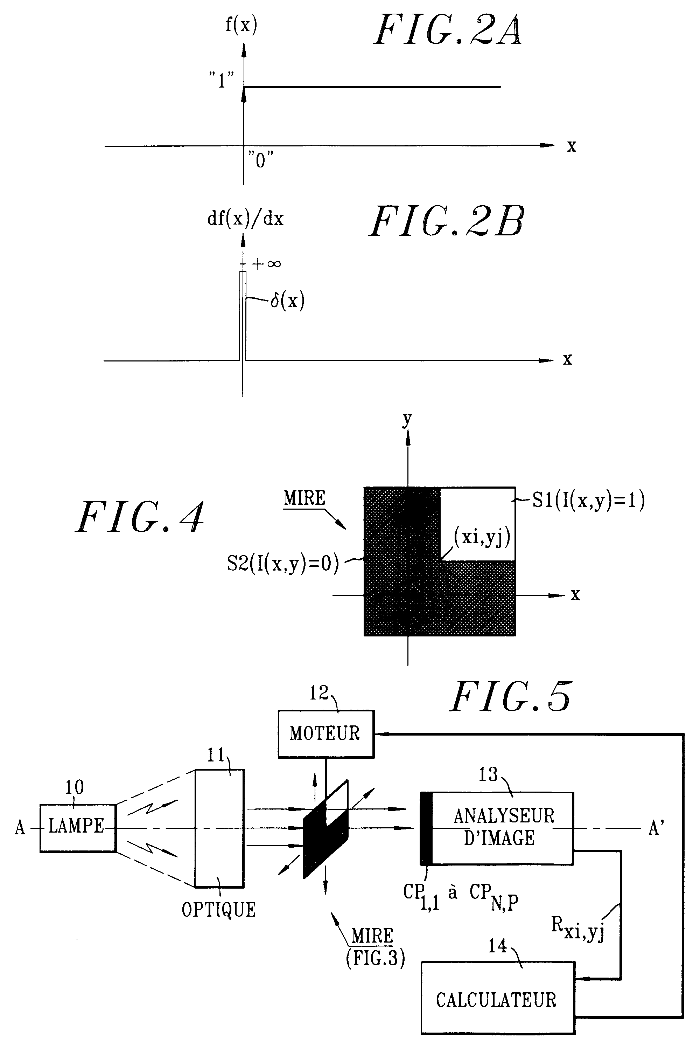

Ainsi la fonction lissée monodimensionnelle dE(x)/dx obtenue à partir des pentes [E(xi) - Ex(i-1)]/(xi-x(i-1)), avec $1<i\leqq I$, de la fonction discrète précitée correspond à une pseudo-fonction caractéristique monodimensionnelle C(x,y) de la cellule. Cette propriété de la fonction dE(x)/dx résulte du fait qu'une fonction f(x) définie par le signal saut unité, par analogie avec la distribution I$_M$(x), possède une dérivée égale à l'impulsion de Dirac $\delta(x)$ comme montré dans les figures 2A et 2B.

Le procédé connu est limité au caractère monodimensionnel de la fonction caractéristique d'une cellule photosensible. Or, la surface sensible d'une telle cellule est par nature bidimensionnelle. Le procédé connu n'est pas en conséquence compatible avec un calcul de l'intensité du signal électrique produit par la cellule pour une quelconque distribution lumineuse reçue par ladite cellule.

L'invention vise à remédier à l'inconvénient précité en fournissant des procédés et systèmes de détermination de la fonction caractéristique bidimensionnelle d'une cellule photosensible, autorisant un calcul de l'intensité du signal électrique produit par la cellule photosensible pour une quelconque distribution d'éclairement lumineux reçue. L'invention contribue à améliorer la caractérisation des analyseurs d'image à cellules photosensibles discrètes.

A cette fin, un procédé de détermination de la fonction caractéristique bidimensionnelle d'une cellule photosensible, comprenant les étapes de:

- illumination d'une surface sensible de ladite cellule à travers une mire, la mire comprenant une surface transparente et une surface opaque,
- déplacement pas à pas de la mire relativement à ladite cellule, et
- calcul différentiel et lissage pour des amplitudes d'un signal électrique produit par la cellule respectivement en réponse à l'illumination de la surface sensible pour des positions de la mire devant la cellule,

est caractérisé en ce que
- la surface opaque est délimitée par des côtés d'un angle par rapport à la surface transparente, l'angle ayant un sommet qui, pour des positions de la mire repérées bidimensionnellement, est respectivement associé à des points d'un quadrillage matriciel d'une zone couvrant ladite surface sensible, et
- le calcul différentiel consiste en un calcul de dérivées partielles bidimensionnelles respectivement pour les positions de la mire repérées bidimensionnellement, la dérivée partielle bidimensionnelle pour une position respective de mire étant calculée en fonction des amplitudes du signal électrique pour la position respective de mire et pour des positions de mire qui sont contiguës à la position respective de mire et situées suivant deux directions respectives parallèles à des côtés dudit angle.

Un système pour la mise en oeuvre de l'invention, comprenant
une mire, une source lumineuse produisant un faisceau lumineux, un moyen optique recevant ledit faisceau lumineux pour former une image de ladite mire sur la surface sensible de la cellule, et un moyen de traitement de signal électrique,
est caractérisé en ce que
sur une face de la mire apparaît un angle dont les côtés délimitent une surface transparente et une surface opaque,
un moyen moteur à déplacement pas à pas suivant deux directions respectivement parallèles aux côtés de l'angle et commandé par le moyen de traitement est prévu pour positionner successivement la mire à des positions repérées bidimensionnellement de mire devant la surface sensible de la cellule, et
le moyen de traitement calcule différentiellement et lisse des amplitudes d'un signal électrique produit par ladite cellule respectivement en réponse à l'illumination de la surface sensible par le faisceau lumineux pour lesdites positions repérées bidimensionnellement afin d'établir une dérivée partielle bidimensionnelle pour chacune des positions repérées bidimensionnellement de la mire en fonction de niveaux pris par ledit signal électrique pour ladite chacune position et des positions de la mire qui sont contiguës à ladite chacune position et situées suivant deux directions respectives parallèles aux côtés dudit angle.

En pratique, la mire est sous la forme d'une lame transparente dont une portion de face supporte un matériau opaque formant ladite surface opaque et est limitée par des chants de la lame et les côtés dudit angle.

L'angle délimitant la surface opaque par rapport à la surface transparente est de préférence rentrant, par exemple sensiblement égal à 270°; ou bien saillant par exemple sensiblement égal à 90°; si bien que la mire est déplacée par le moyen moteur suivant deux directions sensiblement orthogonales.

L'invention n'est pas limitée aux seuls systèmes en transmission et prévoit également la mise en oeuvre du procédé pour des systèmes en réflexion.

A cette fin, un procédé de détermination de la fonction caractéristique bidimensionnelle d'une cellule photosensible, comprenant les étapes de:
- illumination d'une surface sensible de ladite cellule par réflexion d'un faisceau sur une mire, ladite mire comprenant une surface réfléchissante et une surface absorbante ou transparente,
- déplacement pas à pas de la mire relativement à la cellule, et
- calcul différentiel et lissage pour des amplitudes d'un signal électrique produit par ladite cellule respectivement en réponse à l'illumination de ladite surface sensible pour des positions de la mire devant la cellule,
est caractérisé en ce que
- la surface absorbante ou transparente est délimitée par des côtés d'un angle par rapport à la surface réfléchissante, ledit angle ayant un sommet qui, pour des positions de la mire repérées bidimensionnellement, est respectivement associé à des points d'un quadrillage matriciel d'une zone couvrant ladite surface sensible, et
- ledit calcul différentiel consiste en un calcul de dérivées partielles bidimensionnelles respectivement pour lesdites positions de la mire repérées bidimensionnellement, la dérivée partielle bidimensionnelle pour une position respective de mire étant calculée en fonction des amplitudes dudit signal électrique pour ladite position respective de mire et pour des positions de mire qui sont contiguës à ladite position respective de mire et situées suivant deux directions respectives parallèles aux côtés dudit angle.

De préférence l'angle est sensiblement égal à 90° ou 270°.

Un système en réflexion pour la mise en oeuvre du procédé énoncé ci-dessus, comprenant
une mire, une source lumineuse produisant un faisceau lumineux, un moyen optique recevant ledit faisceau lumineux pour former une image de la mire sur la surface sensible de ladite cellule, et un moyen de traitement de signal électrique,
est caractérisé en ce que
sur une face de la mire apparaît un angle dont les côtés délimitent une surface réfléchissante et une surface absorbante ou transparente,

un moyen moteur à déplacement pas à pas suivant deux directions respectivement parallèles aux côtés dudit angle et commandé par ledit moyen de traitement est prévu pour positionner successivement la mire à des positions repérées bidimensionnellement de mire devant la surface sensible de la cellule, et

ledit moyen de traitement calcule différentiellement et lisse des amplitudes d'un signal électrique produit par ladite cellule respectivement en réponse à l'illumination de la surface sensible par le faisceau lumineux pour lesdites positions repérées bidimensionnellement afin d'établir une dérivée partielle bidimensionnelle pour chacune desdites positions repérées bidimensionnellement de la mire en fonction de niveaux pris par ledit signal électrique pour ladite chacune position et des positions de la mire qui sont contiguës à ladite chacune position et situées suivant deux directions respectives parallèles aux côtés dudit angle.

La mire est typiquement sous la forme d'une lame absorbante ou transparente dont une portion d'une face supporte un matériau réfléchissant formant la surface réfléchissante et est limitée par des chants de la lame et les côtés de l'angle.

D'autres caractéristiques et avantages de la présente invention apparaîtront plus clairement à la lecture de la description suivante de plusieurs réalisations préférées de l'invention en référence aux dessins annexés correspondants dans lesquels :
- la figure 1, déjà commentée, est un bloc-diagramme schématique d'un système de détermination de la fonction caractéristique monodimensionnelle d'une cellule discrète selon la technique antérieure;
- les figures 2A et 2B sont respectivement des diagrammes d'une distribution monodimensionnelle d'éclairement lumineux et d'une fonction dérivée de cette distribution;
- la figure 3 est un exemple de représentation graphique d'une fonction caractéristique bidimensionnelle;
- la figure 4 est une vue de face d'une mire pour la mise en oeuvre du procédé selon l'invention; et
- la figure 5 est un bloc-diagramme d'un système pour la mise en oeuvre de l'invention, comprenant la mire de la figure 4.

En référence à la figure 3, une représentation graphique d'une fonction caractéristique bidimensionnelle $C(x,y)$ d'une cellule photosensible élémentaire calculée selon le procédé de l'invention n'est pas fonction seulement d'une dimension, ou variable x, mais dépend des coordonnées $(x,y)$ bidimensionnelles de chaque point de la surface sensible de la cellule photosensible.

Comme montré à la figure 4, une mire MIRE utile à l'invention est une lame rectangulaire transparente à des longueurs d'onde d'un faisceau lumineux, telle que lame de verre, dont une face comporte une surface plane opaque S2 auxdites longeurs d'onde, comme illustrée en zone ombrée. Cette surface opaque est délimitée par les chants de la lame et les côtés d'un angle rentrant en regard d'un coin de la lame. Selon la réalisation illustrée, l'angle rentrant est égal à 270° et a un sommet de coordonnées $(x_i,y_j)$ dans un repère cartésien $(x,y)$ du plan de la mire. Par exemple, la surface opaque S2 résulte du dépôt d'une mince couche d'aluminium, en forme de dièdre ayant une "épaisseur" sensiblement égale à la moitié de l'une des dimensions, largeur et longueur, de la lame. La surface S1 complémentaire à la surface opaque S2 sur la lame est délimitée par un angle saillant complémentaire, égal à 90° selon la réalisation illustrée, et est transparente. Selon une autre variante, la nature transparente et opaque des surfaces S1 et S2 est inversée sans sortir du cadre de l'invention, la surface opaque étant alors une portion rectangulaire de surface avec un angle droit au sommet $(x_i,y_j)$.

Lorsqu'un faisceau lumineux est projeté perpendiculairement à la surface de la mire, l'éclairement lumineux $I(x,y)$ traversant la mire est nul "0" à travers la surface opaque S2 et est maximal "1" à travers la surface transparente S1.

En référence à la figure 5, le système pour la mise en oeuvre du procédé selon l'invention comprend une lampe 10, un dispositif optique de focalisation et de collimation 11, la mire MIRE selon la figure 4, un moyen moteur 12 pour déplacer bidirectionnellement la mire, un analyseur d'image 13 dont l'une de cellules photosensibles élémentaires $CP_{1,1}$ à $CP_{N,P}$ est à caractériser, et un calculateur 14. Dans le cas où l'analyseur 13 ne comprend pas un élément optique de formation d'image, tel qu'objectif dans le cas d'une caméra, un élément d'optique additionnel (non représenté) est placé entre la mire MI et l'analyseur 13. Un faisceau lumineux produit par la lampe 10 est projeté à travers le dispositif optique 11 en un faisceau lumineux collimaté sur une face de la mire. Les chants de la lame de verre constituant la mire sont emprisonnés dans un cadre solidaire de l'élément mobile d'une table micrométrique motorisée verticale constituant le moyen moteur 12 afin que la mire puisse être déplacée suivant deux directions orthogonales à l'axe optique AA' du dispositif 11 et situées dans un plan parallèle et distant de quelques centimètres du plan des cellules photosensibles discrètes $CP_{1,1}$ à $CP_{N,P}$ de l'analyseur 13. L'une $CP_{n,p}$ des cellules $CP_{1,1}$ à $CP_{N,P}$ coïncide sensiblement avec le sommet d'angle rentrant sur la mire pour une position donnée de la mire. Une première portion de la surface sensible de la cellule photosensible $CP_{n,p}$ reçoit un éclairement lumineux maximal "1", et une seconde portion de la surface sensible reçoit un éclairement lumineux nul "0". L'élément optique additionnel (non représenté) ou, si l'analyseur est une caméra, l'objectif de la caméra reçoit le faisceau lumineux à travers ladite mire et forme une image de la mire sur la surface sensible de la cellule photosensible. Ces première et seconde portions de la surface sensible de la cellule photosensible $CP_{n,p}$ sont délimitées, comme les première surface S1 et seconde surface S2 de la mire (figure 4), par les côtés d'un angle droit. Pour des coordonnées données (xi, yj) du sommet d'angle droit rentrant de la surface opaque de la mire, la cellule photosensible $CP_{n,p}$ produit un signal éléctrique $R_{xi,yj}$ d'amplitude égale à:

$$R_{xi,yj} = \int_x\int_y C(x,y).I(x,y).dx.dy,$$

où x et y sont deux variables respectives définies selon des largeur et hauteur de la surface sensible de la cellule photosensible, C(x,y) désigne la fonction caractéristique bidimensionnelle de la cellule photosensible, avec C($\infty$)=0, et I(x,y) la fonction d'éclairement lumineux définie par :

$$\left\{ \begin{array}{l} I\big(xi,\,yi\big) = \text{"1"} \ \ pour \ x \geq xi \ et \ y \geq yj, \\ I\big(xi,\,yi\big) = \text{"0"} \ \ pour \ x < xi \ et \ y < yj \end{array} \right. .$$

Soit $R_{u,v}$ la fonction continue à deux variables associée à la fonction discrète à deux variables précitée $R_{xi,yj}$ et définie pour tout couple (u,v) dans le repère (x,y) du plan de la mire.

La dérivée partielle en u,

$$\frac{\partial}{\partial u}\big( R_{u,\,v} \big),$$

de $R_{u,v}$ est égale à:

$$\int_x\int_y \frac{\partial}{\partial u} c\big(x,\,y\big).\,I\big(u,\,v\big).\,dx.\,dy$$

$$= \int_y dy \int_x \frac{\partial}{\partial u} c\big(x,\,y\big).\,I\big(u,\,v\big).\,dx$$

$$= \int_v^{+\infty} dy \int_u^{+\infty} \frac{\partial}{\partial u} c\big(x,\,y\big)dx \quad ,$$

puisque I(x,y)="1" pour x$\geq$u et y$\geq$v.

Ce dernier résultat s'écrit:

$$\frac{\partial}{\partial u}\big( R_{u,\,v} \big) = \int_v^{+\infty}dy.\big[ c\big(x,\,y\big)\big]_u^{+\infty} = - \int_v^{+\infty} c\big(u,\,y\big)dy . \qquad (4)$$

Par ailleurs la dérivée partielle en v de la fonction définie dans la relation (4) est égale à:

$$\frac{\partial^2}{\partial u \partial v}\big( R_{u,\,v} \big) = - \frac{\partial}{\partial v}\int_v^{+\infty} c\big(u,\,y\big).\,dy \quad ,$$

soit :

$$\frac{\partial^2}{\partial u \partial v}\left(R_{u,v}\right) = -\int_{v}^{+\infty} \frac{\partial}{\partial v} c(u,y)dy \quad = C(u,v)$$

Par conséquent, la double dérivée partielle de la fonction $R_{u,v}$ en u et v est égale à C(u,v). L'invention applique ce résultat mathématique remarquable à la fonction discrète $R_{xi,yj}$ définie précédemment.

Selon l'invention, le moyen moteur 12, sous la commande du calculateur 14, déplace la mire MIRE dans le plan de mire matérialisé par le repère cartésien (x,y). Ainsi le sommet d'angle rentrant de la surface opaque S2 de la mire est successivement localisé à plusieurs positions ayant des abscisses xi telles que $x1 \leq xi \leq xI$ et des ordonnées yj telles que $y1 \leq yj \leq y^J$, coïncidant avec des points discrets respectifs d'une zone incluant la surface sensible de la cellule photosensible $CP_{n,p}$ à caractériser et une bande périphérique à cette surface sensible. Les points discrets définissent un quadrillage matriciel de cette zone. La fonction caractéristique de la cellule photosensible est en effet définie sur une surface, ou zone, ayant des dimensions sensiblement supérieures à celles de la surface sensible de la cellule. La définition de cette zone sensiblement supérieure résulte de fuites de charge intervenant entre cellules photosensibles adjacentes et autres phénomènes physiques.

Des signaux électriques respectifs $R_{xi,yj}$ en sortie de l'analyseur 13 sont obtenus pour lesdites plusieurs positions (xi,yj) et les amplitudes des signaux électriques sont mémorisées dans le calculateur sous la forme d'une matrice

$$\left(R_{xi,yj}\right)_{\substack{1 \leq i \leq I \\ 1 \leq j \leq J}}.$$

Un calcul de pentes différentielles suivant x puis y est effectué en chacun des éléments de la fonction matricielle

$$\left(R_{xi,yj}\right)_{\substack{1 \leq i \leq I \\ 1 \leq j \leq J}}$$

de manière à obtenir une matrice de valeurs approchant la fonction caractéristique C(x,y) en des points respectifs (xi,yj). Un lissage de cette matrice de valeurs conduit à la fonction caractéristique recherchée C(x,y).

Les étapes de calcul et lissage précitées peuvent être inversées sans sortir du cadre de l'invention. Dans ce cas une fonction définie par la fonction continue $R_{u,v}$ précédemment introduite est obtenue par lissage de la matrice

$$\left(R_{xi,yj}\right)_{\substack{1 \leq i \leq I \\ 1 \leq j \leq J}}.$$

A partir de cette fonction continue $R_{u,v}$ est déduite la fonction caractéristique C(x,y) par double dérivée partielle en x et y de $R_{u,v}$.

Il apparaîtra à l'homme du métier que la caractérisation de tout type de cellule photosensible rentre dans le cadre de l'invention, tel que cellule de capteur CCD (Charge-Coupled Device en littérature anglosaxonne) ou photoélément d'une caméra.

De même, il apparaîtra à l'homme du métier qu'un système à fonctionnement en réflexion peut aisément être déduit du système à fonctionnement en transmission montré à la figure 5. Dans un tel montage en réflexion, la lampe et l'analyseur à caractériser sont placés d'un même côté de la mire. La surface opaque et la surface transparente de la mire sont alors respectivement redéfinies en une surface absorbante et une surface réfléchissante sur une face d'une lame absorbante, ou en une surface transparente et une surface réfléchissante sur une face d'une lame transparente afin que le faisceau lumineux produit par la lampe soit partiellement réfléchi par une surface réfléchissante de lame de mire.

Enfin est comprise dans le cadre de l'invention l'application des dispositifs et systèmes décrits à des analyseurs d'image sensibles à des rayonnements autres que dans la lumière visible, tels que rayonnements ultraviolet ou infra-rouge.

## Revendications

**1 -** Procédé de détermination de la fonction caractéristique bidimensionnelle (C(x,y)) d'une cellule photosensible ($CP_{n,p}$ , 13), comprenant les étapes de:
- illumination d'une surface sensible de ladite cellule ($CP_{n,p}$) à travers une mire (MIRE), ladite mire comprenant une surface transparente (S1) et une surface opaque (S2),
- déplacement pas à pas de la mire relativement à la cellule, et
- calcul différentiel et lissage pour des amplitudes d'un signal électrique produit par ladite cellule respectivement en réponse à l'illumination de ladite surface sensible pour des positions de la mire devant la cellule,

caractérisé en ce que
- la surface opaque (S2) est délimitée par des côtés d'un angle par rapport à la surface transparente (S1), ledit angle ayant un sommet (xi,yj) qui, pour des positions de la mire repérées bidimensionnellement, est respectivement associé à des points d'un quadrillage matriciel d'une zone incluant ladite surface sensible, et
- ledit calcul différentiel consiste en un calcul de dérivées partielles bidimensionnelles respectivement pour lesdites positions de la mire repérées bidimensionnellement, la dérivée partielle bidimensionnelle pour une position respective de mire étant calculeé en fonction des amplitudes dudit signal électrique ($R_{xi,yj}$) pour ladite position respective de mire (xi, yj) et pour des positions de mire qui sont contiguës à ladite position respective de mire et situées suivant deux directions respectives parallèles aux côtés dudit angle.

**2 -** Procédé conforme à la revendication 1, selon lequel ledit angle est sensiblement égal à 90° ou 270°.

**3 -** Système pour la mise en oeuvre du procédé conforme à la revendication 1 ou 2,

comprenant une mire (MIRE), une source lumineuse (10) produisant un faisceau lumineux, un moyen optique (11) recevant ledit faisceau lumineux pour former une image de ladite mire sur la surface sensible de ladite cellule, et un moyen de traitement de signal électrique (14),

caractérisé en ce que

sur une face de la mire (MIRE) apparaît un angle dont les côtés délimitent une surface transparente (S1) et une surface opaque (S2),

un moyen moteur (12) à déplacement pas à pas suivant deux directions respectivement parallèles aux côtés dudit angle et commandé par ledit moyen de traitement (14) est prévu pour positionner successivement la mire à des positions repérées bidimensionnellement de mire devant la surface sensible de la cellule, et

ledit moyen de traitement (14) calcule différentiellement et lisse des amplitudes d'un signal électrique produit par ladite cellule respectivement en réponse à l'illumination de la surface sensible par le faisceau lumineux pour lesdites positions repérées bidimensionnellement afin d'établir une dérivée partielle bidimensionnelle pour chacune desdites positions repérées bidimensionnellement de la mire en fonction de niveaux pris par ledit signal électrique ($R_{xi,yj}$) pour ladite chacune position et des positions de la mire qui sont contiguës à ladite chacune position et situées suivant deux directions respectives parallèles aux côtés dudit angle.

**4 -** Système conforme à la revendication 3, dans lequel ladite mire est sous la forme d'une lame transparente dont une portion de face supporte un matériau opaque formant ladite surface opaque (S2) et limitée par des chants de la lame et les côtés dudit angle.

**5 -** Procédé de détermination de la fonction caractéristique bidimensionnelle (C(x,y)) d'une cellule photosensible ($CP_{n,p}$ , 13), comprenant les étapes de:
- illumination d'une surface sensible de ladite cellule ($CP_{n,p}$) par réflexion sur une mire (MIRE), ladite mire comprenant une surface réfléchissante (S1) et une surface absorbante ou transparente (S2),
- déplacement pas à pas de la mire relativement à ladite cellule, et
- calcul différentiel et lissage pour des amplitudes d'un signal électrique produit par ladite cellule respectivement en réponse à l'illumination de ladite surface sensible pour des positions de la mire devant la cellule,

caractérisé en ce que
- la surface absorbante ou transparente (S2) est délimitée par des côtés d'un angle par rapport à la surface réfléchissante (S1), ledit angle ayant un sommet (xi,yj) qui, pour des positions de la mire repérées bidimensionnellement, est respectivement associé a des points d'un quadrillage matriciel d'une zone incluant ladite surface sensible, et
- ledit calcul différentiel consiste en un calcul de dérivées partielles bidimensionnelles respectivement pour lesdites positions de la mire repérées bidimensionnellement, la dérivée partielle bidimensionnelle pour une position respective de mire étant calculée en fonction des amplitudes dudit signal électrique ($R_{xi,yj}$) pour ladite position respective de mire (xi, yj) et pour des positions de mire qui sont contiguës à ladite position respective de mire et situées suivant deux directions respectives parallèles aux côtés dudit angle.

**6** - Procédé conforme à la revendication 5, selon lequel ledit angle est sensiblement égal à 90° ou 270°.

**7** - Système pour la mise en oeuvre du procédé conforme à la revendication 5 ou 6, comprenant

une mire (MIRE), une source lumineuse (10) produisant un faisceau lumineux, un moyen optique (11) recevant ledit faisceau lumineux pour former une image de ladite mire sur la surface sensible de ladite cellule ($C_{n,p}$), et un moyen de traitement de signal électrique (14),

caractérisé en ce que

sur une face de la mire (MIRE) apparaît un angle dont les côtés délimitent une surface réfléchissante (S1) et une surface absorbante ou transparente (S2),

un moyen moteur (12) à déplacement pas à pas suivant deux directions respectivement parallèles aux côtés dudit angle et commandé par ledit moyen de traitement (14) est prévu pour positionner successivement la mire à des positions repérées bidimensionnellement de mire devant la surface sensible de ladite cellule, et

ledit moyen de traitement (14) calcule différentiellement et lisse des amplitudes d'un signal électrique produit par ladite cellule respectivement en réponse à l'illumination de la surface sensible par le faisceau lumineux pour lesdites positions repérées bidimensionnellement afin d'établir une dérivée partielle bidimensionnelle pour chacune desdites positions repérées bidimensionnellement de la mire en fonction de niveaux pris par ledit signal électrique ($R_{xi,yj}$) pour ladite chacune position et des positions de la mire qui sont contiguës à ladite chacune position et situées suivant deux directions respectives parallèles aux côtés dudit angle.

**8** - Système conforme à la revendication 7, dans lequel ladite mire est sous la forme d'une lame absorbante ou transparente dont une portion de face supporte un matériau réfléchissant formant ladite surface réfléchissante (S1) et est limitée par des chants de la lame et les côtés dudit angle.

**9** - Système conforme à l'une quelconque des revendications 3, 4, 7 et 8, dans lequel ledit angle est rentrant, de préférence sensiblement égal à 270°.

**10** - Système conforme à la revendication 3, 4, 7 et 8, dans lequel ledit angle est saillant, de préférence sensiblement égal à 90°.

# *FIG.1*
## (TECHNIQUE ANTERIEURE)

# *FIG.3*

## FIG.2A

f(x)

"1"

"0"

x

## FIG.2B

df(x)/dx

+∞

δ(x)

x

## FIG.4

y

MIRE

S1(I(x,y)=1)

S2(I(x,y)=0)

(xi,yj)

x

## FIG.5

12
MOTEUR

11

10
A — LAMPE

OPTIQUE

13
ANALYSEUR
D'IMAGE

A'

MIRE
(FIG.3)

CP$_{1,1}$ à CP$_{N,P}$

R$_{xi,yj}$

14
CALCULATEUR

11

**Office européen des brevets**

# RAPPORT DE RECHERCHE EUROPEENNE

Numero de la demande

EP 94 40 2856

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US-A-3 630 627 (LOW)<br>* colonne 3, ligne 50 - ligne 73;<br>revendication 1; figure 4 *<br>--- | 1-10 | G01N17/00 |
| A,D | PROCEEDINGS OF SPIE (ECO1, IMAGE PROCESSING II),<br>vol.1027, 19 Septembre 1988, BELLINGHAM, WA, USA<br>pages 40 - 47<br>GLASSER ET AL. 'AN ACCURATE METHOD FOR MEASURING THE SPATIAL RESOLUTION...'<br>--- | 1-10 | |
| A | GB-A-2 086 609 (HUMPHREY INSTRUMENTS)<br>* figure 1 *<br>----- | | |

**DOMAINES TECHNIQUES RECHERCHES (Int.Cl.6)**

G01N
G01R

Le présent rapport a été établi pour toutes les revendications

| Lieu de la recherche | Date d'achèvement de la recherche | Examinateur |
|---|---|---|
| LA HAYE | 24 Mars 1995 | Iwansson, K |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)